# EUROPEAN PATENT SPECIFICATION

(11) **EP 0 858 667 B1**
(45) Date of publication and mention of the grant of the patent: **02.01.2004**
(21) Application number: 97926176.5
(22) Date of filing: 26.06.1997
(51) Int. Cl.: H01F 27/28

(54) **CHOKE**
DROSSELSPULE
BOBINE D'AMORTISSEMENT

(30) Priority: 01.08.1996 US 692293
(43) Date of publication of application: 19.08.1998
(73) Proprietor: Koninklijke Philips Electronics N.V., 5621 BA Eindhoven (NL)
(72) Inventor: EASTON, Robert, W., NL-5656 AA Eindhoven (NL); DESJARDINS, Edgar, E., NL-5656 AA Eindhoven (NL); HOUCK, Jeffrey, L., NL-5656 AA Eindhoven (NL)
(74) Representative: Wolfs, Marc Johannes Maria
(86) International application number: PCT/IB1997/000793
(87) International publication number: WO 1998/006113

(56) References cited:
- SE-C- 112 738

## Description

This invention relates in general to chokes and in particular to an AC power passing RF choke for use in a coaxial cable system that provides both AC power and RF signal distribution. The abbreviation "AC" stands for "alternating current, whereas the abbreviation "RF" stands for "radio frequency".

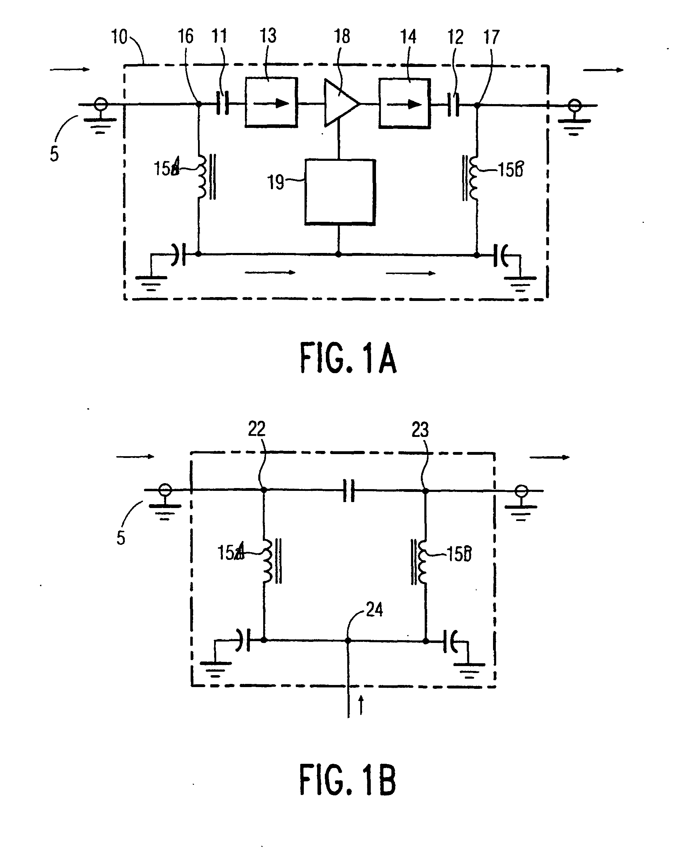

Coaxial cable systems that deliver both video and audio signals to the consumer also, provide AC power for powering RF signal amplifiers that are placed along the length of the coaxial cable distribution. In order to separate the AC power from the RF signal so that the AC power can be used to power the amplifiers, chokes are used as shown in Fig. 1A. Similarly, in order to insert power into the coaxial cable systems, line power inserters employing chokes are used as shown Fig. 1B. A choke which is intended for use in such coaxial cable systems is described in U.S. Serial No. 08/295,444. In such RF/AC distribution systems the high-frequency RF signals are subject to spurious modulation with the AC power supply frequency (hum modulation "HUM-MOD") owing to non-linearities caused by hysteresis and saturation effects in the choke ferrite core. A power passing choke intended for use in these systems therefor must have both low RF signal loss and low HUM-MOD distortion as defined by the National Cable Television Association (NCTA) standards.

Chokes in use today are constructed of round wire wound on a ferrite core. Typically these types of chokes can pass up to 8A (Amps). The new cable communications systems provide increased video and data services, therefore, AC power requirements have increased substantially. Requirements for AC current passing of 15A (Amps) and 25A (Amps) sustaining during faults presently exists, along with increased RF bandwidth approaching 1000 MHZ.

With 20A (Amp) AC passing, choke operating temperature can reach 200 degrees C in stagnant air. Increasing choke wire diameter reduces winding AC dissipation but because of the helix winding periodic structure, RF losses also increase in several resonance frequency bands within the operating RF frequency range. This increase in RF losses increases HUM-MOD in these frequency bands.

SE 112 738 A describes a choke in accordance with the preamble of claim 1.

It is an object of the present invention to provide an AC power passing RF choke that has the potential for useful performance to permit 20a (Amp) AC power passing, sustain 30A (Amps) AC during line faults and have a frequency of operation from 5 MHz to above 1000 MHz. Such an AC power passing RF choke must inject into the cable system less than -70 dB HUM-MOD as defined by the NCTA standards. In order to reach these severe HUM-MOD specifications, it is required to take additional measures to increase the resonance damping. This object can be realized according to the present invention by providing a resistive coating bonded to the surface of the bare ribbon wire. This increases series damping resistance R. The resistive coating must be in electrical contact with the ribbon wire surface to insure that the RF surface current flows in the resistive coating. Since the AC passing current flows uniformly in the ribbon wire cross-section, this surface resistance coating causes little increase in AC dissipation.

A feature of the present invention is to lower choke operating temperature without increasing HUM-MOD by using ribbon wire for the choke winding. To limit choke operating temperature, bare ribbon wire with it's flat side in contact with the core transfers heat from the ribbon wire into the core. A core made of nickel-zinc iron oxide ferrite composition is used which has a high electrical resistivity and does not shunt the AC current into the core.

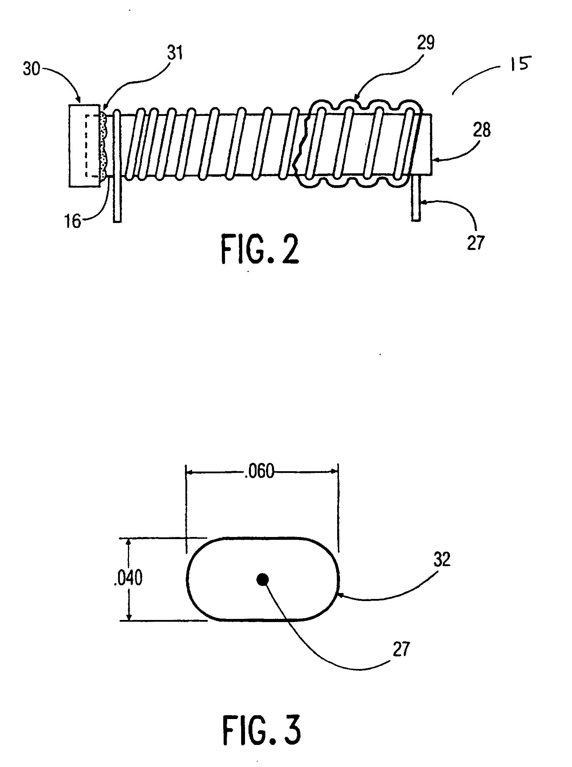

A feature of the invention is to use a high thermal conductivity bonding epoxy to hold the core to an aluminum heat sink. Thus, the intrinsic thermal conductivity of the ferrite provides heat transfer from the core through the high thermal conductivity bonding epoxy into the aluminum heat sink (Fig. 2A). With 20A (Amp) AC passing, this design feature can limit choke temperature rise to 50 degrees C above heat sink temperature. For an equivalent round wire cross section area, ribbon wire exhibits less HUM-MOD. This difference is attributed to increased core coupling with ribbon wire, where core RF loss provides partial damping of helix resonances.

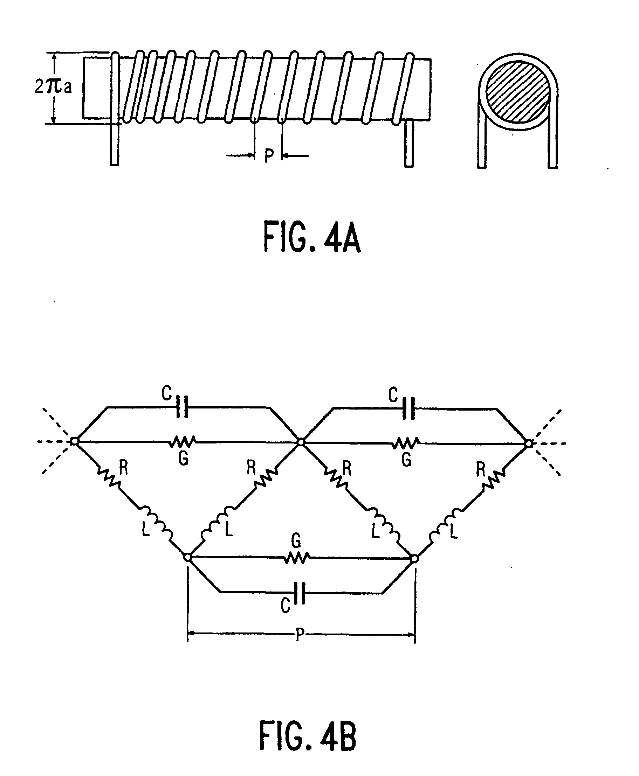

Another feature of the invention is to use a non-uniform pitch or spacing between adjacent helix turns to disrupt the periodic resonance thereby improving HUM-MOD (Fig. 4). In Fig. 4 for a choke diameter equal to (a) the length of a single winding turn is 2πa, and the axial spacing between adjacent windings is the pitch(p).

Yet other features of the invention pertain to the electrical characteristics of the windings. In Fig. 4B one-half of a single Helix winding is represented by a resistance (R) in series with an inductance (L). Between adjacent windings, for a given pitch, a conductance (G) and a capacitance (C) are in shunt across a single winding. (It should be noted that circuit parameters are uniformly distributed, however, they are shown discrete for illustrative purposes). The series resistance R results from the ribbon conductor resistivity and the RF surface current characteristics of a small penetration into the ribbon conductor, referred to as "skin depth". The series resistance R increases with the square root of frequency and is the primary cause of damping resonances at increasing RF frequencies. The Ni-Zn ferrite core has a high DC volume resistance to prevent shorting the 60 Hz AC signal. High frequency RF core losses provide some resonance damping, however additional damping is required to meet the HUM-MOD specifications. The shunt conductance (G) is primarily due to RF losses in the ferrite core. An increase in both the series resistance of the ribbon wire and shunt conductance of the ferrite core is required to maintain -70 dB HUM-MOD in resonant frequency bands.

Another object of the invention increases the shunt conductance G of the of the windings by conformal heat-shrinking a conductive polymer sleeve over the choke winding. Due to the choke's high operating temperature the polymer's temperature stability with aging is a design consideration.

Yet a further object of the invention combines both series and shunt damping by conformal over spraying the bare ribbon wound choke with a single resistive coating that is temperature cured to provide an impermeable bonded coating that resists aging with choke high operating temperature.

This single conformal coating adds series damping resistance to the ribbon wire surface facing away from the core, and shunt damping between adjacent helix turns. An optimum coating resistance and thickness can be determined to meet the HUM-MOD requirements. An advantage of this single conformal coating is that the bare ribbon wire facing the core provides maximum heat transfer. Nominal coating resistivity in the range of 200 to 1000 Ohm/Square at 0.025mm (1.0 mil) thickness is sufficient, however, optimum resistivity is choke specifications dependent.

It will thus be seen that the objects and features set forth above, among those made apparent from the description, are efficiently attained and since certain changes may be made in carrying out the method and in the construction set forth without departing from the scope of the invention as claimed, it is intended that all matter contained in the description and shown in the accompanying drawings shall be interpreted as illustrative and not in a limiting sense.

For a fuller understanding of the invention reference is made to the following drawings:
Fig. 1A shows an amplifier constructed with choke coils in accordance with the invention;
Fig. 1B shows a line power inserter constructed with choke coils in accordance with the invention;
Fig. 2 shows a side view of a choke coil in accordance with the invention;
Fig. 3 shows a cross section of the ribbon wire shown in Figs. 2 and 4A;
Fig. 4A shows a choke coil in accordance with a preferred embodiment of the invention and including a cross-sectional view of the choke coil;
Fig. 4B is a circuit diagram representing the resistances, conductances and capacitances on and between the coils of the choke coil of Figs. 2A and 4A.

Fig. 1A shows the use of a choke in accordance with the invention in an amplifier 10. The coaxial cable 5 is cut and an amplifier 10 is inserted therebetween. Chokes 15A and 15B are used to bypass the amplifier 10 with the AC current. The AC current is then used to power the DC power supply 19 which in turn powers the amplifying device 18. The AC current is bypassed at node 16 through the choke 15A. Capacitor 11 ensures that amplifier 18 is protected from the AC current. The RF signal is provided to a signal director 13 and then to amplifier 18. The amplified signal from the amplifier 18 is provided to another signal director 14. The AC signal is added back to the RF signal at node 17 once it passes again through another choke 15B. Another capacitor 12 is provided to protect the output of amplifier 10 from the AC current.

Fig. 1 B shows another use of the choke in accordance with the invention. Again the coaxial cable 5 is cut and a line power inserter is inserted therebetween. This use of the chokes 15A and 15B provides the AC current to the RF signal in the coaxial cable. The RF signal is provided at node 22. The AC signal can be provided in either direction along the coaxial cable. Choke 15A is used to provide the AC signal back up the coaxial cable. Choke 15B is used to provide the AC signal down the coaxial cable. The AC power is provided to node 24 and added to the RF signal via choke 15B at node 23 and added to the RF signal via choke 15A at node 22. The combined RF/AC signal is then delivered to the rest of the cable network.

The chokes used in Figs. 1A and 1B must meet the increased capacity requirements of passing at least 20A (Amps), sustaining 30A (Amps) and having an RF frequency of operation from 5 MHz to above 1000 MHz. In addition the choke cannot inject into the RF signal more than -70 dB HUM-MOD.

Fig. 2 shows a choke 15 in accordance with a preferred embodiment of the invention. A ferrite core 28 is provided. This core 28 is primarily Ni-Zn ferrite and has a high DC volume resistivity. End section 16 is bonded to a heatsink 30. A thermally conductive epoxy 31 is provided to connect core 28 to heatsink 30. The ribbon wire 27 is wound with its flat end against the core to improve heat transfer from wire to core. The epoxy 31 improves heat transfer from the core 28 to the heatsink 30. The heatsink 30, in a preferred embodiment is made of aluminum and limits the core 28 operating temperature. Ribbon wire 27 is wound around core 28 and it is wound such that the widest part of the ribbon wire 27 is against the core 28 or in other words, substantially parallel to and in contact with the core 28. The ribbon wire 27 is shown in Fig. 3 and is provided with a resistive coating 32.

According to the invention the invention bare ribbon wire 27 is wound around core 28 and a single conformal coating is applied to the ribbon wire surface that is facing away from the core and couples each turn to an adjacent turn. This single conformal coating can be optimized for both series resistance and shunt conductance yet the bare ribbon wire facing the core provides maximum heat transfer. Nominal coating resistivity in the range of 200 to 1000 ohm/square at 0.025mm (1.0 mil) thickness for optimum resistivity is choke specification dependent. The use of the ribbon wire 27 provides high AC current passing but, with its conductor coating reduces the parasitic resonances caused by capacitive coupling between turns when compared to round wire. This is because the broad surface of the ribbon wire 27 provides increased ferrite core capacitive coupling where core RF losses provides damping of resonances.

In an embodiment of the invention a heat shrinkable conductive polymer sleeve 29 having a resistive layer is placed in electrical contact with and over the ribbon wire turns 27. This sleeve 29 provides two functions. The first is to provide firm contact of the ribbon wire 27 with the ferrite core 28 for effective heat exchange. The second is its conductive property provides damping of parasitic resonances. Fig. 4B shows an electric circuit diagram that describes the capacitances conductances and resistances that can be detected on and between the windings.

Each winding is shown in Fig. 4B as a resistance R and an inductance L. There is also a shunt conductance G and capacitive coupling C that exists between the turns, thus, there inherently exists an R, L, G and C circuit with resonances in several frequency bands that increase HUM-MOD. Because inductance L and capacitance C are determined by the ribbon wire windings, the only variables to damp resonances is to change R or G. To change R to damp the resonances, R is increased by providing a resistive surface coating 32 on the ribbon wire 17 as shown in Fig. 3. As R increases the resonances are reduced. In addition after the ribbon wire 27 is wound on the core a separate shunt conductance G is added. This shunt conductance is obtained by using the conductive polymer sleeve 29 as explained above, or by spraying a resistive coating over the ribbon wire coils after they are wound around the core.

To further eliminate the resonances, as shown in Fig. 2, the coils of the ribbon wire 27 are stagger wound across the core 28, thus resonances caused by the capacitive coupling between the inductor turns 27 will differ in frequency across the length of the core 28 instead of accumulating at one frequency and creating an amplification effect.

In a preferred embodiment of the invention a first resistive spray is used to provide coating 32 which increases R. The ribbon wire 27 is sprayed before it is wound around the core and a second resistive spray is used to coat the ribbon wire 27 after it is wound around the core to provide the shunt conductance between inductor turns. A high temperature compound with carbon filler can be used for both coatings, and the resistance can vary depending on the properties of the carbon filler.

Fig. 3 shows a cross section of the ribbon wire 27. The AC current typically flows through the center of the wire 27 whereas the RF at the higher frequencies flows through the resistive coating 32. This is called the skin effect. The surface coating 32 therefore does not affect the AC signal dissipation.

As explained above, instead of using two separate coatings of a resistive spray a single coating that is applied after the ribbon wire is wound on the core and that conductively couples the turns together is an alternative embodiment.

In the preferred embodiment where a single resistive compound is used, a Dupont Electronics Materials 7082 carbon conductor polymer thick film composition is used which has a primary property of 6.2.10⁵ ohm/mm² (400 ohm/sq/mil) and a viscosity of 210-260 Pa.s (PAS), in conjunction with a silicon rubber compound having a -40 C to 230 C temperature resistance. The two materials are combined in a 1:1 ratio by volume. The bare ribbon wire is wound around the core and the mixture is applied over the ribbon wire windings using a spatula. The entire coil and core is then cured at room temperature for three hours minimum or in an oven at 200 C for thirty minutes.

The invention accordingly comprises the features of construction, combination of elements, and arrangement of parts which are exemplified in the constructions set forth, and the method comprises the several steps and the relation of one or more of such steps with respect to each of the others, and the scope of the invention will be indicated in the claims.

## Claims

1. A choke (15), comprising:
- a ferromagnetic core (28);
- an elongated coil of substantially flat metal ribbon (27) whose width is greater than its thickness, the ribbon (27) being wound around a core (28) in a helix form of turns such that the width of the ribbon (27) is substantially parallel to the surface, **characterized in that** the ribbon (27) is coated with a first resistive coating (32) prior to the winding.

2. A choke (15) according to Claim 1, wherein a second resistive coating is applied over the wound helix form of turns so as to make electrical contact with the turns and conductively couple them to one another.

3. A choke (15) according to Claim 1 or 2, wherein the pitch of the helix around the core is non-uniform.

4. A choke (15) according to Claim 1 or 2, further comprising a heatsink (30) which is attached to the core using a thermally conductive adhesive.

5. A choke (15) according to Claim 1, 2, 3 or 4, wherein the second resistive coating is a conductive polymer sleeve that is heat-shrunk over the turns of the ribbon wire so as to conductively couple the turns together.

6. A choke (15) according to Claim 1, 2, 3 or 4, wherein the first and second resistive coatings comprise a sprayed carbon-filled compound having a high temperature base.

7. An amplifier (10) for amplifying an RF signal along a cable distribution system (5) providing both an RF signal and an AC signal, the amplifier (10) comprising:
- a choke (15A, 15B) according to any of the Claims 1-6;
- an amplifying device (18) for amplifying the RF signal.

8. An amplifier (10) for amplifying an RF signal along a cable distribution system (5) providing both an RF signal and an AC signal, the amplifier (10) comprising:
- a first choke (15A) according to any of the Claims 1-6;
- an amplifying device (18) for amplifying the RF signal;
- a second choke (15B) constructed substantially similar to the first choke, and
- a DC power supply (19),
the two chokes (15A, 15B) being coupled together at a node, the node being coupled to the DC power supply (19), an end of the first choke (15A) being coupled to a cable (5) and to an input of the amplifying device (18), an end of the second choke being coupled to another cable and to an output of the amplifying device (18), such that the amplifying device (18) is placed in series between the cables.

9. A line power inserter for inserting AC power into an RF cable distribution system (5), comprising:
- a first choke (15A) according to any of the Claims 1-6;
- a second choke (15B) constructed substantially similar to the first choke (15A) and coupled thereto at a node (24), the node (24) being coupled to receive the AC power, a free end of the first choke (15A) being coupled to a first cable and a free end of the second choke (15B) being coupled to a second cable, and
- a capacitor coupled between the cables.

## Patentansprüche

1. Drosselspule (15) mit:
- einem ferromagnetischen Kern (28);
- einer länglichen Spule aus im Wesentlichen flachem Metallband (27), dessen Breite größer als dessen Dicke ist, wobei das Band (27) in wendelförmigen Wicklungen so um einen Kern (28) gewickelt ist, dass die Breite des Bands (27) im Wesentlichen parallel zu der Oberfläche ist, **dadurch gekennzeichnet, dass** das Band (27) vor der Wicklung mit einer ersten Widerstandsbeschichtung (32) versehen wird.

2. Drosselspule (15) nach Anspruch 1, wobei eine zweite Widerstandsbeschichtung über den gewickelten, wendelförmigen Wicklungen vorgesehen ist, um einen elektrischen Kontakt mit den Wicklungen herzustellen und sie miteinander leitend zu verbinden.

3. Drosselspule (15) nach Anspruch 2, wobei der Schritt des Wendels um den Kern ungleichmäßig ist.

4. Drosselspule (15) nach Anspruch 1 oder 2, welche weiterhin eine Wärmeableitvorrichtung (30) aufweist, die an dem Kern mit Hilfe eines wärmeleitenden Klebemittels befestigt ist.

5. Drosselspule (15) nach Anspruch 1, 2, 3 oder 4, wobei die zweite Widerstandsbeschichtung durch eine Hülle eines leitenden Polymers dargestellt ist, welche über den Wicklungen des Banddrahts so aufgeschrumpft ist, dass sie die Wicklungen miteinander leitend verbindet.

6. Drosselspule (15) nach Anspruch 1, 2, 3 oder 4, wobei die erste und zweite Widerstandsbeschichtung eine aufgesprühte Hochtemperaturverbindung mit Kohlenstoff-Füllmaterial aufweisen.

7. Verstärker (10) zum Verstärken eines HF-Signals entlang eines Kabelverteilungssystems (5), welcher sowohl ein HF-Signal als auch ein Wechselstromsignal abgibt, wobei der Verstärker (10) aufweist:
- eine Drosselspule (15A, 15B) nach einem der Ansprüche 1-6;
- einen Verstärker (18) zum Verstärken des HF-Signals.

8. Verstärker (10) zum Verstärken eines HF-Signals entlang eines Kabelverteilungssystems (5), welcher sowohl ein HF-Signal als auch ein Wechselstromsignal abgibt, wobei der Verstärker (10) aufweist:
- eine erste Drosselspule (15A) nach einem der Ansprüche 1-6;
- einen Verstärker (18) zum Verstärken des HF-Signals;
- eine zweite Drosselspule (15B), welche im Wesentlichen wie die erste Drosselspule ausgeführt ist; sowie
- eine Gleichspannungsquelle (19),
wobei die beiden Drosselspulen (15A, 15B) an einem Knoten miteinander verbunden sind, der Knoten an die Gleichspannungsquelle (19) gekoppelt ist, ein Ende der ersten Drosselspule (15A) an ein Kabel (5) und einen Eingang des Verstärkers (18) gekoppelt ist, ein Ende der zweiten Drosselspule mit einem weiteren Kabel und einem Ausgang des Verstärkers (18) verbunden ist, so dass der Verstärker (18) in Reihe zwischen den Kabeln vorgesehen ist.

9. Netzstrom-Inserter, um AC-Leistung in ein HF-Kabelverteilungssystem (5) einzufügen, welcher aufweist:
- eine erste Drosselspule (15A) nach einem der Ansprüche 1-6;
- eine zweite Drosselspule (15B), welche im Wesentlichen wie die erste Drosselspule (15A) ausgeführt ist und an einem Knoten (24) an diese gekoppelt ist, wobei der Knoten (24) so geschaltet ist, dass er AC-Leistung aufnimmt, ein freies Ende der ersten Drosselspule (15A) mit einem ersten Kabel und ein freies Ende der zweiten Drosselspule (15B) mit einem zweiten Kabel verbunden ist; und
- ein Kondensator zwischen den Kabeln geschaltet ist.

## Revendications

1. Bobine d'arrêt (15), comprenant :
- un noyau ferromagnétique (28);
- un enroulement allongé d'un ruban de métal essentiellement plat (27), dont la largeur est plus grande que son épaisseur, le ruban (27) étant enroulé autour d'un noyau (28) sous la forme de spires hélicoïdales telle que la largeur du ruban (27) soit essentiellement parallèle à la surface, **caractérisé en ce que** le ruban (27) est enrobé d'un premier revêtement résistif (32) avant l'enroulement.

2. Bobine d'arrêt (15) selon la revendication 1, dans laquelle un second revêtement résistif est appliqué par-dessus la forme des spires enroulées en hélice, de façon à établir un contact électrique avec les spires et à les relier l'un à l'autre de façon conductrice.

3. Bobine d'arrêt (15) selon la revendication 1 ou 2, dans laquelle le pas de l'hélice autour du noyau est non uniforme.

4. Bobine d'arrêt (15) selon la revendication 1 ou 2, comprenant en outre un dissipateur thermique (30) qui est attaché au noyau au moyen d'un adhésif conducteur de la chaleur.

5. Bobine d'arrêt (15) selon la revendication 1, 2, 3 ou 4, dans laquelle le second revêtement résistif est un manchon polymère conducteur qui est thermorétracté par-dessus les spires du fil ruban de façon à relier les spires l'un à l'autre de façon conductrice.

6. Bobine d'arrêt (15) selon la revendication 1, 2, 3 ou 4, dans laquelle les premier et second revêtements résistifs comprennent un composé pulvérisé chargé de carbone, ayant une base pour haute température.

7. Amplificateur (10) pour amplifier un signal RF le long d'un système de distribution par câble (5) procurant un signal RF et un signal CA, l'amplificateur (10) comprenant :
- une bobine d'arrêt (15A, 15B) selon l'une quelconque des revendications 1 à 6,
- un dispositif amplificateur (18) pour amplifier le signal RF.

8. Amplificateur (10) pour amplifier un signal RF le long d'un système de distribution par câble (5) procurant un signal RF et un signal CA, l'amplificateur (10) comprenant :
- une première bobine d'arrêt (15A) selon une quelconque des revendications 1 à 6,
- un dispositif amplificateur (18) pour amplifier le signal RF;
- une seconde bobine d'arrêt (15B) construite d'une manière essentiellement similaire à la première bobine d' arrêt, et
- une alimentation d'énergie CC (19),
les deux bobines d'arrêt (15A, 15B) étant connectées l'une à l'autre à un noeud, le noeud étant connecté à l'alimentation d'énergie CC (19), une extrémité de la première bobine d'arrêt (15A) étant connectée à un câble (5) et à une entrée du dispositif d'amplification (18), une extrémité de la seconde bobine d'arrêt étant connectée à un autre câble et à une sortie du dispositif d'amplification (18), de façon que le dispositif d'amplification (18) soit placé en série entre les câbles.

9. Élément d'insertion d'énergie secteur pour insérer une énergie CA dans un système de distribution RF par câble (5), comprenant :
- une première bobine d'arrêt (15A) selon une quelconque des revendications 1 à 6,
- une seconde bobine d'arrêt (15B) construite d'une manière essentiellement similaire à la première bobine d'arrêt (15A) et connectée à celle-ci à un noeud (24), le noeud (24) étant connecté pour recevoir l'énergie CA, une extrémité libre de la première bobine d'arrêt (15A) étant connectée à un premier câble et une extrémité libre de la seconde bobine d'arrêt (15B) étant connectée à un second câble, et
- un condensateur connecté entre les deux câbles.
